# EUROPEAN PATENT APPLICATION

(11) **EP 2 273 680 A1**
(43) Date of publication of application: **12.01.2011**
(21) Application number: 09290490.3
(22) Date of filing: 25.06.2009
(51) Int. Cl.: H03L 7/099

(54) **System and method for linearising the gain of a digitally controlled oscillator**

(71) Applicant: NXP B.V., 5656 AG Eindhoven (NL)
(72) Inventor: Ridgers, Timothy John, Redhill, Surrey RH1 1DL (GB); Philippe, Pascal, Redhill, Surrey RH1 1DL (GB); Jean, Patrick, Redhill, Surrey RH1 1DL (GB)
(74) Representative: Williamson, Paul Lewis

(57) **Abstract**

A system (100) for linearising a gain of a digitally controlled oscillator (101,410), wherein the system (100) comprises a calibration circuit (120) for estimating one or more values indicative of frequencies of the digitally controlled oscillator and a digital circuit (130,430) for coding control bits on the basis of the one or more estimated values, wherein the control bits control the digitally controlled oscillator so that the gain of the digitally controlled oscillator is linearised.

## Description

### FIELD OF THE INVENTION

The invention relates to a system and method for linearising the gain of a digitally controlled oscillator.

### BACKGROUND OF THE INVENTION

In the field of radios, telecommunications, computers and other electronic applications, devices implemented in fine lithographic CMOS will replace many functions with digital equivalents. This permits higher performance with ease-of-design and improves the time to develop new products. In this context, much recent attention has been put on implementing fully digital phase-locked loops (PLLs).

Phase-locked loops are widely used for synchronization purposes; in space communications for coherent carrier tracking and threshold extension, bit synchronization, and symbol synchronization. Phase-locked loops can also be used to demodulate frequency-modulated signals. In radio transmitters, a PLL is used to synthesize new frequencies that are a multiple of a reference frequency with the same stability as the reference frequency. In a digital PLL, the loop filter provides a control word, coded across many bits, to set the local oscillator frequency in a digitally-controlled oscillator (DCO).

A key requirement for a digitally controlled oscillator is to span a wide frequency tuning range. The need for a wide frequency tuning range is driven by the need to cover a wide range of operating frequencies, which frequencies are determined by the system or systems for which the radio is designed. The need for a wide frequency tuning range is also driven by the need to cope with initial variations in component values during manufacturing. Additionally, the minimum DCO frequency step needs to be particularly small. For instance, in cellular applications a resolution of 1 kHz is needed on a 1 GHz carrier.

U.S. Pat. No. 6,658,748 discloses a fully digitally-controlled LC tank oscillator (DCO) that uses a bank of more significant binary-weighted and/or less significant equally-weighted capacitors that are switched between only two voltage potentials. The time-averaged value of capacitance of predetermined less significant capacitors is determined by dithering between the two states to achieve a further refinement in the resolution of the resonating frequency.

### SUMMARY OF THE INVENTION

A system for linearising the gain of a digitally controlled oscillator, a method of linearising the gain of a digitally controlled oscillator, a program element, and a computer-readable medium are disclosed.

According to an embodiment of the invention, a system for linearising the gain of a digitally controlled oscillator is provided wherein the system includes a calibration circuit for estimating one or more values indicative of frequencies of the digitally controlled oscillator and a digital circuit for coding control bits on the basis of the one or more estimated values. The control bits control the digitally controlled oscillator so that the gain of the digitally controlled oscillator is linearised.

According to another embodiment of the invention, a method of linearising the gain of a digitally controlled oscillator is provided. The method involves estimating one or more values indicative of frequencies of the digitally controlled oscillator and coding control bits on the basis of the one or more estimated values, wherein the control bits control the digitally controlled oscillator so that the gain of the digitally controlled oscillator is linearised.

According to still another embodiment of the invention, a program element (for instance a software routine, in source code or in executable code) is provided, which, when executed by a processor, is adapted to control or carry out a gain linearising method having the above mentioned features.

According to yet another embodiment of the invention, a computer-readable medium (for instance a semiconductor memory, a CD, a DVD, a USB stick, a floppy disk or a harddisk) is provided, in which a computer program is stored which, when executed by a processor, is adapted to control or carry out a gain linearising method having the above mentioned features.

Linearising the gain according to embodiments of the invention can be realized by a computer program, that is, in software, or by using one or more special electronic optimization circuits, that is, in hardware, or in hybrid form, that is by means of software components and hardware components.

Conventional digitally controlled oscillators have as a key requirement, spanning a wide frequency tuning range. The need for a wide frequency range arises both from the need to cover a wide range of operating frequencies, determined by the system, or systems for which the radio is designed, and also from the need to cope with initial variations in component values during manufacturing. Additionally, the minimum DCO frequency step needs to be particularly small. For instance, in cellular applications, a resolution of 1 kHz is needed on a 1 GHz carrier. In an embodiment, the oscillator frequency is programmed to estimated values. This allows the DCO frequency tuning range to be increased without being operated at very high frequencies and without consuming significant current. This embodiment provides a simple circuit with simple function for little current.

In a first step, the oscillator frequency is programmed to the estimated values by changing many steps of the DCO. Many steps are changed to enable measurement of the average frequency of different devices of the DCO, removing a random contribution of a specific device. The DCO frequencies are measured via a PLL counter, using as a reference a crystal oscillator and the frequency step are computed. Independently in a second step, the DCO frequency is measured for two or more programmed values. In both cases, the average of the setting of devices of the DCO of the previous measurements may be used.

Subsequently, the estimated values are sent to the digital circuit. The digital circuit codes control bits taking into account the estimated values and controls the DCO on the basis of the control bits to linearise the gain of the DCO.

In the following, further embodiments of the device will be explained. However, these embodiments also apply to the method, to the program element, and to the computer-readable medium.

In an embodiment, the digital circuit includes a multiplier which is coupled with an output of the calibration circuit. The estimated values are added to a programming word by the multiplier to code the control bits.

In an embodiment, the digitally controlled oscillator includes a resonator tank circuit. A cross-coupled transistor pair provides for a negative resistance sufficient to cause oscillation to start and then to replace losses in the resonator tank. The balanced circuit reduces common-mode effects and disturbances. The resonator tank circuit incorporates mutually coupled coils. The impedance level of the coils is set both as a function of the peak current and the voltage during operation at the wanted frequency.

In an embodiment, the digitally controlled oscillator includes a bank of unit tuning capacitance elements ohmly coupled to the resonator tank circuit. The term "ohmly" is used to denote tightly or directly coupled. The term "bank of unit tuning capacitance" is used to denote a bank of capacitors in combination with switches. Preferably, such a bank of unit tuning capacitance elements includes two parallel capacitors, each coupled in series with a switch.

In an embodiment, the digitally controlled oscillator includes at least one bank of unit tuning capacitance elements capacitively coupled to the resonator tank circuit through a series capacitor. The term "capacitively" is used to denote that the bank of unit tuning capacitance elements is lightly coupled to the resonator bank. In an embodiment, the lightly coupled bank of unit tuning capacitance elements are similar to or the same as the ohmly coupled bank of unit tuning capacitance elements.

In an embodiment, the digital circuit is configured to code the control bits separately for each of the capacitor unit tuning banks. Therefore, the DCO may be controlled very exactly. The system may be a phase-locked loop. In a digital phase-locked loop, the loop filter provides a control word, coded across many bits, to set the local oscillator frequency in a digitally controlled oscillator. An all digital PLL may be used to synthesize the local oscillator frequency to operate an RF transceiver, for instance to perform signal processing between antenna and baseband circuits to establish a radiocommunication link conforming to standards such as, but not limited to, GSM, EDGE, UMTS, CDMA, Bluetooth, WLAN and DECT. A mostly digital approach, as indicated by the terminology, lends itself more readily to be built and integrated within an advanced sub-micron CMOS technology such as 90, 65 or 45nm nodes. Furthermore, a digital circuit can be integrated with other digital functions such as digital signal processing, microprocessor and memory management functions of a baseband circuit, and to create a SOC (System-on-Chip). In an embodiment, the estimated values are a relative weight of the different capacitor bank elements. Further, the calibration circuit is adapted to measure the frequencies of the digitally controlled oscillator over a specific period to generate the estimated values. The estimated values may be counters arising from the digitally controlled oscillator. In an embodiment, there are two sets of counters.

In an embodiment, a first set of counters performs a frequency division in the normal operation of a synthesizer. For example, an integer synthesizer that locks a 4GHz oscillator to a multiple of 1MHz, using a 16MHz reference frequency, would have one counter that takes as its input the 4GHz signal and divides by nominally 4000 to give the 1MHz phase comparison frequency, and a second counter that takes as its input the 16MHz reference and divides by 16 to again deliver 1MHz for phase comparison. Then, if instead of creating 4GHz, it is needed to set the VCO to 4.001 GHz the first counter can be programmed to divide by 4001. So these two counters may normally function within a PLL.

The precision of the result of such counters is relatively coarse, here in the example with a 1MHz raster, the frequency of the VCO can only be estimated to within 1MHz. In order to perform a calibration of the digitally controlled oscillator, additional counters may be added to extend the count range of the normal synthesizer operation. For example, to measure the VCO frequency down to 10kHz, it may be necessary to count 100 cycles of the normal 1 MHz phase comparison period. During this time, the number of cycles of the VCO frequency may be accumulated so as to estimate its frequency to within 1 count value, or to within 10 kHz. Conventionally, both sets of counters, those for normal PLL operation and those added to perform finer frequency measurement, may be used to calibrate the VCO gain.

In an embodiment, the system further includes at least one thermometer decoder for adding or removing unit capacitors within the banks according to the estimated values. The term "thermometer decoder" is used herein to denote a digital circuit that has at its inputs a signal coded across multiple bits wherein the value of the signal is represented by a combination of bit states. For instance in a binary coded signal, the bits have different weights which are powers of 2, so for instance a signal coded with 4 bits can take on 16 distinct values from 0 to 15. The decoder has at its outputs a set of signals each of which has the same weight. The signals are successively activated in a linear fashion as the input code changes, only one bit changes state at each increment of the input code. In the example of a 4 bit binary input there would be 16 outputs.

In an embodiment, the digital circuit is adapted to split a programming word into a most significant part and a least significant part. The term "part" may denote one or more bits. The digital circuit controls the tightly coupled bank via the most significant bits and the lightly coupled banks via the least significant bits.

In an embodiment, the least significant part constitutes the control bits. The digital control circuit controls the bits used to switch the capacitors in the lightly coupled bank. The input signal that is used to control both banks is normally binary coded. So the most significant bits are assigned to the tightly coupled bank, which has greater unit weight. The least significant bits represent the fractional part of a unit capacitor of the tightly coupled bank. These bits are then scaled according to the relative weight of the unit capacitor in each of the banks.

Other aspects and advantages of example embodiments of the present invention will become apparent from the following detailed description, taken in conjunction with the accompanying drawings, illustrated by way of example of the principles of the invention.

### BRIEF DESCRIPTION OF THE DRAWINGS

Fig. 1 depicts a conventional circuit architecture of a VCO.

Fig. 2 is a graph showing different step sizes between two capacitor banks.

Fig. 3 depicts a device for linearising the gain of a digitally controlled oscillator according to an embodiment of the invention.

Fig. 4 is a functional block diagram that illustrates the functioning of an all-digital PLL in accordance with an embodiment of the invention.

Fig. 5 depicts a device for linearising the gain of a digitally controlled oscillator according to an embodiment of the invention.

Throughout the description, similar reference numbers may be used to identify similar elements.

### DESCRIPTION OF EMBODIMENTS

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

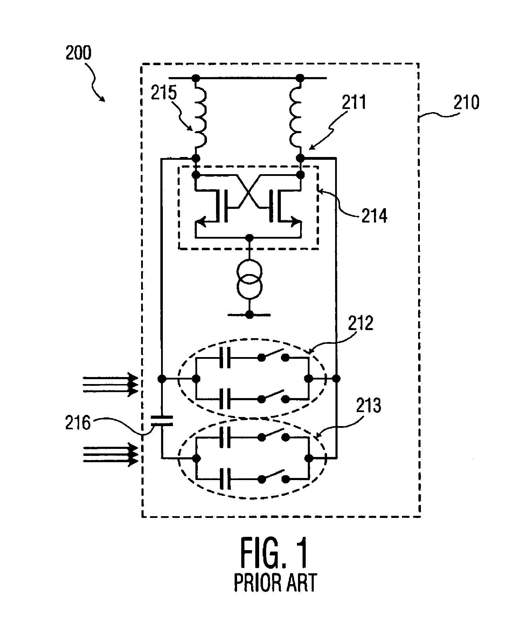

Referring to Fig. 1, a conventional circuit architecture 200 used to implement a voltage-controlled oscillator 210, VCO, is explained. The VCO 210 comprises a tank resonator circuit 211. A cross-coupled transistor pair 214 provides for a negative resistance sufficient to cause oscillation to start and then to replace losses in the resonator tank circuit 211. The balanced circuit reduces common-mode effects and disturbances. The resonator tank circuit 211 incorporates mutually coupled coils 215. In an embodiment, the impedance level of the coils 215 is set both as a function of the peak current and the voltage during operation at the wanted frequency.

Normally, the inductor impedance will be increased, since generally a higher quality factor can be obtained, resulting in lower power consumption for a given phase noise performance. However, increasing the inductor impedance has some drawbacks. Firstly, the higher the inductor impedance, the more die area that is needed, and therefore the higher the cost. Secondly, as the tank impedance increases, the capacitor values must be smaller. This in turn makes it more difficult to achieve a given tuning range, since the range of available capacitances is constrained by the smallest capacitor element that can be added to the resonator tank circuit. For most aggressive CMOS technologies the smallest capacitive element that can be created is typically only 100aF. Still, when combined with a typical inductance of 0.5nH, for an oscillator running at 4GHz this enables a frequency step that is several 10s of kHz, which is at least an order of magnitude larger than required. A tuning range of sixteen bits is achievable, but this falls short of the twenty bits required.

An approach used in VCO design is to lightly couple a tuning element 213, such as a varicap, to the resonator tank circuit 211. For example, a fixed capacitor 216 is placed in series with the variable capacitance 213 and connected to the resonator tank circuit 211. In this way, a change in the variable capacitance as seen from the resonator tank circuit presents a diluted adjustment by the relative weighting of the fixed and variable capacitance parts.

Hence, by lightly coupling the minimum-size unit capacitors to the tank resonator circuit 211, smaller tuning steps can be created. Unfortunately, any series capacitor integrated within a CMOS process also tends to have a parasitic capacitance to ground, which will affect the oscillation frequency. Since any variable capacitance will also be characterized by a minimum to maximum capacitance ratio, the presence of additional parasitic capacitance can only reduce the overall oscillator tuning range.

Therefore, it is mostly preferred to avoid using such series capacitors so as to achieve the widest possible tuning range and improve manufacturability. Unfortunately, if all of the tuning elements are only lightly coupled to the resonator tank, then the resulting effect is to take the same dynamic range of adjustment and move it to a lower weighting. For instance, if a variable capacitance that is tightly or directly coupled to the resonator tank circuit 211 allows the VCO to be tuned between 10% and 100 ppm of the nominal center frequency, when diluted through a fixed series capacitor, which reduces its influence to one tenth, then the VCO would only be able to be tuned from 1% to 10ppm of the nominal center frequency. If both a wide tuning range and a small frequency step are simultaneously required then both tightly or directly and lightly coupled elements, 212 and 213 respectively, can be used to achieve sufficient dynamic range. This configuration allows for tuning from 10% to 10ppm, thereby extending the tuning range by one order of magnitude.

Based on the above description, it is desirable to combine both types of tuning. Matching the gain of both types of tuning elements is necessary but not straightforward. One way to match the gains of the tuning elements is to use the same component types for both the fixed 216 and variable 212, 213 capacitances.

Unfortunately, components optimized as variable capacitors are not necessarily suitable to implement the fixed capacitance. For instance the switched capacitance offering the highest quality factor in a typical standard CMOS process employs a MOS transistor channel biased in one of two regions - depleted (off) and enhanced (on). The capacitance between gate and shorted drain-source terminals varies between a 2:1 to 3:1 ratio, while the Q factor can be greater than 15 to 30 depending on the technology. The quality factor or Q factor is a dimensionless parameter that compares the time constant for decay of an oscillating physical system's amplitude to its oscillation period.

Such a component, if used as a series capacitance creates problems with respect to biasing. For instance, the parasitic junction diodes can be polarized into conduction by the tank voltage swing. This changes the capacitance and introduces losses which then seriously degrade the Q factor. Such a non-linear behavior may also introduce other unwanted effects such as noise folding. It is therefore preferred to use a metal-metal capacitance for series capacitance, which intrinsically offers high linearity and low parasitic capacitance to ground. However, the relative weight of the two types of tuning elements changes with manufacturing since the two capacitor types vary independently. If the two path gains from tightly and lightly coupled capacitors are not aligned, a serious nonlinearity error will ensue. Such an error ultimately renders the use of two paths inoperable, since the resulting quantization step error can be very significant.

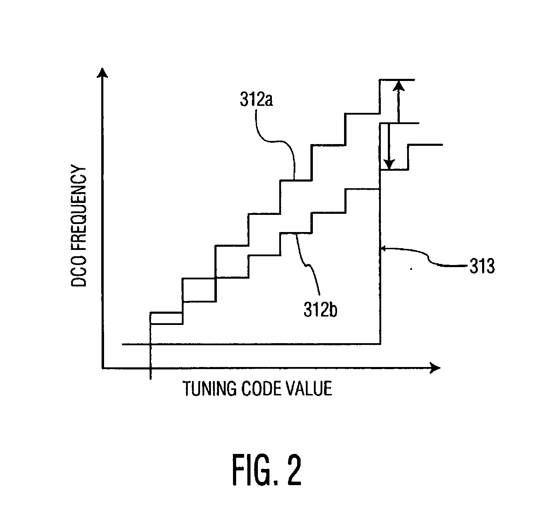

Fig. 2 is a graph showing different tuning steps between two capacitor banks. The graph shows a magnified view of a small part of the DCO transfer curve. The horizontal axis of the graph represents the tuning code value and the vertical axis of the graph represents the DCO frequency. The graph illustrates the frequency change in the DCO transfer curve for a few steps created by adding unit capacitors to the tightly coupled bank (line 313).

Ideally, it should be possible to linearly add many steps of the lightly coupled unit capacitor bank. This is illustrated by the staircased DCO transfer curves 312a and 312b, the former having larger than nominal step sizes, the latter showing smaller than nominal step sizes. For instance, whereas the lightly coupled band would normally code eight frequency steps, an additional 3bits resolution, depending on the series coupling capacitor to activate eight unit devices may introduce a cumulated frequency shift that is 20% greater than expected (312a) or 20% less than expected (as indicated by DCO transfer curve 312b). Alternatively, the wanted frequency change may be caused by activating only six unit devices if coupled too strongly (e.g., DCO transfer curve 312a) or by activating ten unit devices if coupled too weakly (e.g., DCO transfer curve 312b).

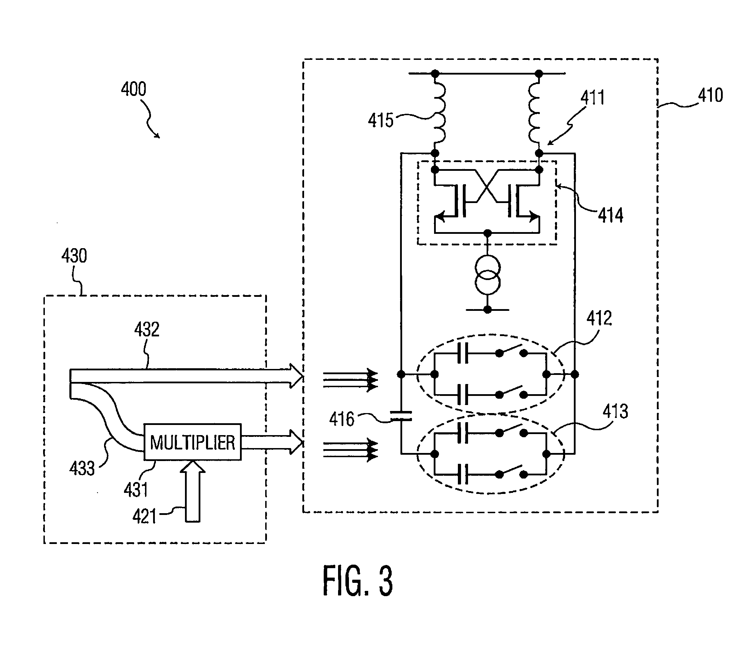

Fig. 3 depicts a device for linearising the gain of a digitally controlled oscillator according to an exemplary embodiment of the invention. The system 400 includes a DCO 410 that has a bank of unit tuning capacitance elements 412 tightly coupled to the resonator tank circuit 411, at least one bank of unit tuning capacitance elements 414 lightly coupled to the resonator tank circuit 411 through a series capacitor 416, and a digital circuit 430 that separately codes control bits to each of the multiple capacitor tuning banks. The digital circuit employs a multiplier 431. The system 400 further includes a calibration circuit (not shown) that estimates the relative weight of the capacitor bank unit elements.

Operation of the system 400 is now described. The description includes a calibration operation and a normal operation. In a first step of the calibration operation, the oscillator frequency is programmed to two values by changing many steps of the tightly coupled unit capacitors 412. Many steps are changed to enable measurement of the average frequency per unit capacitor, thereby removing the random contribution of a specific capacitor component. The two DCO frequencies are measured via PLL counters using as a reference a crystal oscillator. Next, the frequency step per tightly coupled unit capacitor is computed. Independently in a second phase, the DCO frequency is again measured for two more programmed values. In both cases the average of the setting of the tightly coupled unit capacitors of the previous measurements is used. All of the lightly coupled unit capacitors 413 are programmed in one case to be active and in a second case all of the lightly coupled unit capacitors 413 are programmed to be inactive. The frequency step per lightly coupled unit capacitor is then computed. From the above-described two computations, the relative weight of the tightly and lightly coupled unit capacitor banks is calculated and provided as a weighting coefficient 421. The weighting coefficient is then stored for use during normal DCO operation.

During normal DCO operation, the programming word used to set the instantaneous DCO frequency is split into two parts - a most significant part 432 and a least significant part 433. The most significant part 432 contains the bits assigned to control the largest frequency steps. These bits are sent to a thermometer decoder (not shown), which individually adds or removes unit capacitors within the tightly coupled bank 412 in response to the most significant part 432. The least significant bits 433 contain the bits used to program the lightly coupled capacitor bank 413. This part of the programming word is first adjusted by multiplication (via multiplier 431) using the weighting coefficient 421 previously calculated during the calibration operation. The result is forwarded to a thermometer decoder (not shown), which individually adds or removes unit capacitors within the lightly coupled bank 413.

In order to cope with gains that could be either too high or too low, the weighting coefficient 421 is able to take values greater or less than one. To this end, in an embodiment, the lightly coupled unit capacitor bank 413 and the corresponding thermometer decoder are configured to handle additional capacitor elements beyond that which is normally required for a given precision - for instance 11 unit devices may be provided for 3 bits, thereby permitting a weighting coefficient of 11/7 of nominal.

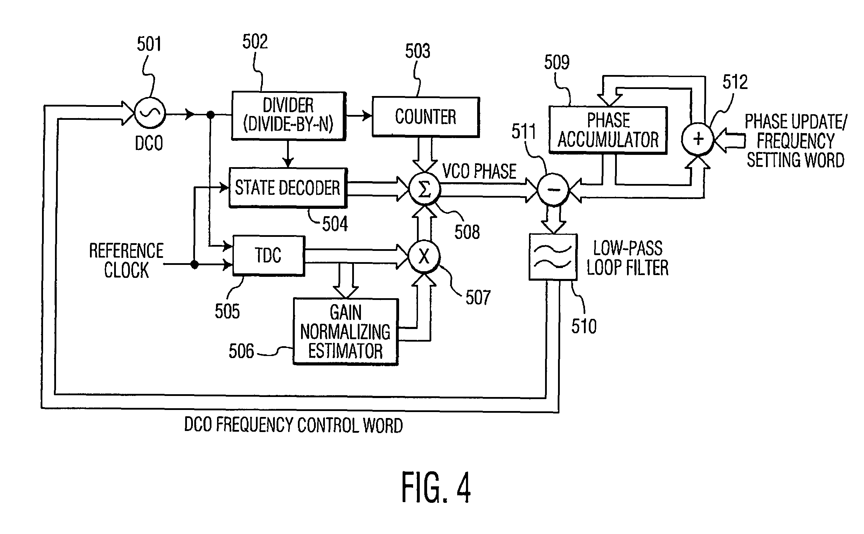

Fig. 4 is a functional block diagram of an all-digital PLL. A digitally controlled oscillator (DCO) 501 receives a control word to set its center frequency. The output of the DCO drives a divider 502 whose internal state is changed at each active input clock edge. When the divider 502 exceeds a maximum count, as determined by the number of divider stages, an overflow clock signal is generated to drive a counter 503.

An input reference clock determines the rate at which the PLL calculates and subsequently adjusts the DCO frequency to a predetermined value. Once per reference clock cycle, for instance on the clock rising edge, the state of the divider 502 is read by a state decoder 504. Such a state decoder can be built with an appropriate structure using logic gates and bistables. Combining the states of the state decoder 504 and the counter 503 in a Σ (sum) block 508 gives the accumulated number of complete DCO cycles. The combining operation simply involves alignment of the bits of the two words if the divider 502 operates with a period between overflow clocks that is a power of 2 multiple of the input clock pulse. The resulting word provides the accumulated oscillator phase to the nearest 2π radians. For instance, if we consider an oscillator operating at 4GHz, a typical LO frequency used in a GSM transceiver, the precision obtained in time is to within 250ps.

In an embodiment, providing phase information that is finer than the period of the oscillator clock (DCO), that is to encode phase information below 2π, requires the addition of a Time-to-Digital Converter, or TDC 505. In an embodiment of the TDC 505, a set of nominally identical delay elements compares the time between the reference clock edge and the next oscillator edge. The reference clock initiates the measurement and the next oscillator edge terminates the measurement until the next reference cycle. For instance if delay elements of nominally 25ps are employed, the TDC is able to resolve the accumulated oscillator phase to a tenth of its period when running at 4GHz, or to within 0·2π radians. The increased resolution produces a lower quantisation noise associated with the phase measurement and results in a lower phase noise introduced by the frequency synthesizer.

In an embodiment, combining the output code produced by the TDC 505 and the sum oscillator cycles in a phase consistent form requires normalising the TDC unit delay to the period of the DCO at its specific operating frequency. The gain normalisation is undertaken by two blocks: a gain normalising estimator 506 and a multiplier 507, which adjusts the TDC output code by a proportionality constant that is determined by the gain normalising estimator 506.

The resulting total oscillator phase is then compared with the expected /wanted phase by subtraction at subtractor 511. The wanted phase is created in a phase accumulator 509. At each reference cycle the expected/wanted phase from the phase accumulator 509 is updated to a value resulting from the sum (via sum block 512) of the previous result with a phase update/frequency-setting word. As the name suggests, the phase update/frequency-setting word sets the oscillator output frequency in relation to the reference clock. The phase update/frequency-setting word is coded across many bits to allow sufficient synthesis precision. For instance to create RF frequencies centered on 4GHz to a precision of a few 10s of Hz requires coding the phase update/frequency-setting word across twenty-seven bits.

Part of the phase update/frequency-setting word encodes complete oscillator cycles per reference period, which is integer increments of 2π and part of the phase update/frequency-setting word encodes fractions of a cycle, or phase information much less than 2π radians. For instance, for a reference clock at 26MHz, a common frequency used in systems operating according to the GSM standard, the number of 4GHz oscillator cycles that accumulate per reference period is ∼ 156. So the integer phase information can be encoded using eight bits, leaving nineteen bits (from the earlier example) to encode the fractional phase information (portion of 2π). In the case of a frequency-modulated PLL, the phase update/frequency-setting word can be dynamically adjusted at each reference cycle to introduce changes in the oscillator output frequency.

The difference between the phase measured by the circuit blocks 502, 503, 504 and 505, and combined at sum block 508, with the consigned phase accumulated in the phase accumulator 509 represents the phase error that drives the PLL lock. These digital values are then subtracted at subtractor 511. The resultant is the input to a low-pass loop filter 510. In its simplest form, the low-pass loop filter 510 is a gain circuit to create a first-order feedback loop, more often a second order filter is implemented including a zero to ensure adequate stability of the feedback loop. The output of the low-pass loop filter is the word that sets the DCO frequency. The output of the low-pass loop filter is updated at the reference frequency rate.

Initial manufacturing tolerances are typically such that the oscillator center frequency may be as much as 10% off from the nominal value for a particular frequency code setting word. Thus in many synthesizers, before phase-lock, the circuit is placed in a frequency pre-calibration mode, in which coarse frequency errors are reduced. To perform this calibration, the number of DCO cycles is counted during a measurement time that is a multiple of the reference frequency. This gives a fair indication of the initial frequency and frequency error, for which the DCO can be compensated by adjusting the code word before starting phase-lock. The measurement time can be defined by counting a predetermined number of reference cycles with a counter: for instance an 8-bit counter allows 256 reference clock periods to be accumulated. During calibration, the number of DCO cycles is significantly greater than during normal PLL operation. In an embodiment, the counter 503 is extended by an equivalent number of bits that are used to set the measurement period, here for instance eight bits.

Thus, if the reference frequency is 26MHz, a common value for a cellular synthesizer, then the counting of 256 periods gives a measurement period nearly equal to 10µs. Simply taking into account the number of complete DCO cycles allows the frequency to be estimated to within 100kHz. If the initial imprecision is up to 10% of 4GHz, that is to within±400MHz, then this error can be corrected by several orders of magnitude by appropriate adjustment of the initial frequency code word.

Successively measuring the DCO frequency with different frequency setting words allows the DCO gain to be estimated; that is, the variation in output frequency for a given change in the input code can be estimated. In an embodiment, a first frequency setting code is applied to generate a first estimated DCO frequency and a second frequency setting code is applied to generate a second estimated DCO frequency. The gain is obtained by subtracting the second frequency from the first frequency and then dividing the frequency difference by the result of subtracting the second frequency setting code from the first frequency setting code.

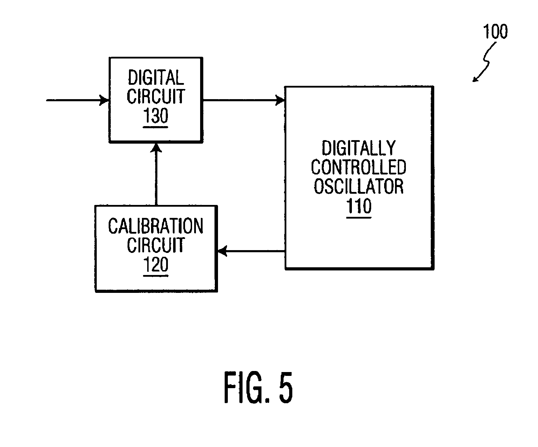

Fig. 5 depicts a functional block diagram of a system 100 for linearising the gain of a digitally controlled oscillator 110 according to an exemplary embodiment of the invention. In the embodiment of Fig. 5, the system 100 includes a calibration circuit 120 for estimating one or more values indicative of frequencies of the digitally controlled oscillator 110 and a digital circuit 130 for coding control bits on the basis of the one or more estimated values. The control bits control the digitally controlled oscillator so that the gain of the digitally controlled oscillator is linearised. In a first step, the oscillator frequency is programmed to the estimated values by changing many steps of the DCO. Many steps are changed as described above to enable measurement of the average frequency of different devices of the DCO, thereby removing a random contribution of a specific device. The DCO frequencies are measured via a PLL counter, using as a reference a crystal oscillator. The frequency step is then computed. Independently in a second step, the DCO frequency is again measured for two or more programmed values. In both cases, the average of the setting of devices of the DCO of the previous measurements is used.

Subsequently, the estimated values are sent to the digital circuit 130. The digital circuit codes control bits taking into account the estimated values and controls the DCO 110 on the basis of the control bits to linearise the gain of the DCO.

The present invention may be implemented, for example, by operating a computer system to execute a sequence of machine-readable instructions. The instructions may reside in various types of computer readable media. In this respect, another aspect of the present invention concerns a programmed product, comprising computer readable media tangibly embodying a program of machine readable instructions executable by a digital data processor to perform a method for distributing forwarding information in a distributed architecture router.

This computer readable media may comprise, for example, RAM contained within the system. Alternatively, the instructions may be contained in another computer readable media such as a magnetic data storage diskette and directly or indirectly accessed by the computer system. Whether contained in the computer system or elsewhere, the instructions may be stored on a variety of machine readable storage media, such as a DASD storage (e.g. a conventional "hard drive" or a RAID array), magnetic tape, electronic read-only memory, an optical storage device (e.g., CD ROM, WORM, DVD, digital optical tape), paper "punch" cards, or other suitable computer readable media including transmission media such as digital, analog, and wireless communication links. In an illustrative embodiment of the invention, the machine-readable instructions may comprise lines of compiled C, C++, or similar language code commonly used by those skilled in the programming for this type of application arts.

It shall be appreciated that not all methods steps described must be performed, nor must they be performed in the order stated.

It should be noted that the term "comprising" does not exclude other elements or features and the "a" or "an" does not exclude a plurality. Also elements described in association with different embodiments may be combined.
It should also be noted that reference signs in the claims shall not be construed as limiting the scope of the claims.

## Claims

1. A system (100) for linearising the gain of a digitally controlled oscillator (110), the system (100) comprising:
a calibration circuit (120) for estimating one or more values indicative of frequencies of the digitally controlled oscillator; and
a digital circuit (130) for coding control bits on the basis of the one or more estimated values, wherein the control bits control the digitally controlled oscillator so that the gain of the digitally controlled oscillator is linearised.

2. The system (100) according to claim 1, wherein the digital circuit (130) comprises a multiplier (431) coupled with an output of the calibration circuit (120).

3. The system (100) according to claim 1, wherein the digitally controlled oscillator (110) comprises a resonator tank circuit (411).

4. The system (100) according to claim 1, wherein the digitally controlled oscillator (110) comprises a bank of unit tuning capacitance elements (412) ohmly coupled to the resonator tank circuit (411).

5. The system (100) according to claim 4, wherein the digitally controlled oscillator (110) comprises at least one bank of unit tuning capacitance elements (413) capacitively coupled to the resonator tank circuit (411) through a series capacitor (416).

6. The system (100) according to claim 5, wherein the digital circuit (130) is adapted to code the control bits separately for each of the capacitively coupled banks (413).

7. The system (100) according to any of the claim 6, wherein the estimated values are a relative weight of the different unit tuning capacitance elements (413) of the capacitively coupled banks.

8. The system (100) according to any of the claim 7, comprising at least one thermometer decoder for adding or removing unit tuning capacitance elements within the ohmly coupled and capacitively coupled banks (412, 413) according to the estimated values.

9. The system (100) according to claim 8, wherein the digital circuit (130) is adapted to split a programming word into a most and a least significant part.

10. The system (100) according to claim 9, wherein the least significant part comprises the control bits that control the capacitively coupled banks.

11. The system (100) according to any preceding claim, wherein the system is a phase-locked loop.

12. The system (100) according to any preceding claim, wherein the calibration circuit (120) is adapted to measure the frequencies of the digitally controlled oscillator (110) over a specific period to estimate the estimated values.

13. A method for linearising a gain of a digitally controlled oscillator (110), the method comprising:
estimating one or more values indicative of frequencies of the digitally controlled oscillator; and
coding control bits on the basis of the one or more estimated values, wherein the control bits control the digitally controlled oscillator so that the gain of the digitally controlled oscillator is linearised.

14. The method of claim 13 wherein the digitally controlled oscillator comprises:
a bank of unit tuning capacitance elements (412) ohmly coupled to a resonator tank circuit (411); and
at least one bank of unit tuning capacitance elements (413) capacitively coupled to the resonator tank circuit (411) through a series capacitor (416).

15. The method of claim 14 wherein the estimating comprises programming the frequency of the digitally controlled oscillator to two values by changing many steps of the ohmly coupled banks.

16. The method of claim 15 further comprising measuring the frequency of the digitally controlled oscillator for two or more programmed values.

17. The method of claim 16 wherein the frequency measurements are made in a first case in which all of the capacitively coupled banks are active and in a second case in which all of the capacitively coupled banks are inactive.

18. A computer-readable medium, in which a computer program of linearising a gain of a digitally controlled oscillator is stored, which computer program, when executed by a processor, is adapted to carry out or control a method according to claim 13.

19. A program element of linearising a gain of a digitally controlled oscillator, which program element, when executed by a processor, is adapted to carry out or control a method according to claim 13.
